(19) **Europäisches Patentamt**
**European Patent Office**
**Office européen des brevets**

(11) **EP 4 228 385 B1**

(12) **EUROPÄISCHE PATENTSCHRIFT**

(45) Veröffentlichungstag und Bekanntmachung des Hinweises auf die Patenterteilung:
**16.10.2024  Patentblatt 2024/42**

(21) Anmeldenummer: **22155900.8**

(22) Anmeldetag: **09.02.2022**

(51) Internationale Patentklassifikation (IPC):
***H05K 13/08*** *(2006.01)*

(52) Gemeinsame Patentklassifikation (CPC):
**H05K 13/085**

(54) **COMPUTERIMPLEMENTIERTES VERFAHREN ZUR BESTIMMUNG EINER OPTIMALEN ZUORDNUNG VON BAUGRUPPENTYPEN ZU EINER HINSICHTLICH SEINER BESTÜCKUNGSLEISTUNG AUSGEWÄHLTEN BESTÜCKUNGSLINIE**

COMPUTER-IMPLEMENTED METHOD FOR DETERMINING AN OPTIMAL ALLOCATION OF COMPONENT TYPES TO AN ASSEMBLY LINE SELECTED WITH REGARD TO ITS LOADING PERFORMANCE

PROCÉDÉ MIS EN OEUVRE PAR ORDINATEUR DE DÉTERMINATION D'UNE AFFECTATION OPTIMALE DES TYPES DE MODULE À UNE LIGNE DE MONTAGE SÉLECTIONNÉE EN FONCTION DE SON PERFORMANCE DE MONTAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**16.08.2023  Patentblatt 2023/33**

(73) Patentinhaber: **Siemens Aktiengesellschaft**
**80333 München (DE)**

(72) Erfinder:
• **Pfaffinger, Alexander**
**81739 München (DE)**
• **Royer, Christian**
**85521 Ottobrunn (DE)**

(74) Vertreter: **Siemens Patent Attorneys**
**Postfach 22 16 34**
**80506 München (DE)**

(56) Entgegenhaltungen:
**WO-A1-2019/011412     JP-B2- 5 963 873**

**Beschreibung**

Die Erfindung betrifft ein computerimplementiertes Verfahren zur Bestimmung einer optimalen Zuordnung von Baugruppentypen zu einer hinsichtlich seiner Bestückungsleistung ausgewählten Bestückungslinie und eine Anordnung mit Steuerungssystem und Steuerungsvorrichtung sowie ein zugehöriges Computerprogrammprodukt.

Insbesondere im Bereich der Elektronikproduktion werden zu fertigende Leiterplatten bzw. Baugruppen auf SMT-Bestückungslinien durch Oberflächenmontage (SMT = surface mounted technology) hergestellt. Die Elektronikproduktion bzw. -fertigung ist geprägt durch hohe Anforderungen an kurze Durchlaufzeiten, hohe Produktivität (u.a. kurze Umrüstzeiten, kurze Produktionszeiten, usw.) und hohe Flexibilität.

Mehrere Bestückungsautomaten, die üblicherweise durch ein Transportsystem verbunden sind, und die z.B. zum Fertigen bzw. Bestücken von (Elektronik-)baugruppen zusammenwirken, stellen eine Bestückungslinie dar.

In den industriellen Fertigungswerken im Bereich der Elektronikproduktion werden zu fertigende Baugruppen (bzw. Leiterplatten) in Aufträgen mit fest vorgegebenen Losgrößen produziert.

Durch die Losgrößen wird implizit festgelegt, wie häufig eine Baugruppe zu produzieren ist. Je kleiner die Losgröße einer Baugruppe ist, umso häufiger muss diese Baugruppe produziert werden und umso größer sind die Rüstaufwände.

Die Erstellung einer (Bauelement-)Rüstung, auch Setup genannt, für eine Bestückungslinie benötigt ca. 6-8 Stunden und verursacht somit einen enormen Aufwand. Die Produktion der Baugruppen erfolgt somit in Rüstfamilien. Eine Rüstfamilie ist dabei eine Menge von Baugruppentypen, die mit einer Rüstung auf der Bestückungslinie produzierbar sind.

Mit anderen Worten ausgedrückt umfasst eine Rüstfamilie, auch Cluster genannt, eine Menge von Losen, die innerhalb einer Rüstung gefertigt werden kann. Alle Baugruppen der Baugruppentypen einer Rüstfamilie können also nacheinander ohne Umrüsten auf der Bestückungslinie gefertigt werden.

Eine Rüstung kann auf einem oder mehreren Rüsttischen gehalten werden, die leicht am Bestückungsautomaten ausgewechselt werden können. Ein Aufrüsten eines Rüsttischs mit Bauelementen von vorbestimmten Bauelementtypen ist jedoch aufwändig. Die Rüstungen werden daher oft in Festrüstungen und Variantenrüstungen unterschieden, wobei eine Festrüstung auf einem Rüsttisch dazu vorgesehen ist, seine Zusammensetzung von Bauelementtypen über einen vorbestimmten Planungshorizont zu behalten, während ein Variantenrüsttisch voraussichtlich innerhalb des Planungshorizonts umgerüstet wird.

Aus EP 2 893 791 B1 ist ein Verfahren zur Bestimmung einer möglichst vorteilhaften Festrüstung für eine Bestückungslinie bekannt. Dieses Verfahren berücksichtigt jedoch nicht, dass mehrere Bestückungslinien eines Bestückungssystems idealerweise in ihren zugeordneten Leiterplattentypen aufeinander abgestimmt werden sollten, um die parallele Produktion von Leiterplatten unterschiedlicher Leiterplattentypen möglichst effizient zu gestalten.

In EP 3 219 180 B1 wird das Problem aus EP 2 893 791 B1 für mehrere Bestückungslinien eines Bestückungssystems gelöst.

In WO 2019/011412 A1 wird ein Verfahren zur durchlaufzeitoptimierten Produktion von Leiterplatten auf einer Bestückungslinie, wobei die Leiterplatten jeweils eine Taktzeit in der Produktion aufweisen und in Gruppen bzw. Cluster aufgeteilt sind.

In JP 5963873 B2 wird das Problem angesprochen, das die Zykluszeit zweier hintereinandergeschalteter Fertigungsmaschinen nicht zusammenpassen, dass dann ein Flaschenhals entsteht.

Beide vorgenannten Dokumente beziehen sich jedoch nur auf eine Fertigungslinie.

Nun gibt es in industriellen Fertigungswerken häufig eine oder mehrere ausgewählte Bestückungslinien, auch Rennerlinie genannt, die eine hohe Bestückungsleistung aufweisen. Die Rennerlinien werden vornehmlich mit Festrüstungen oder zumindest einem hohen Festrüstungsanteil betrieben. Auf den verbleibenden "normalen" Bestückungslinien mit vergleichsweise niedrigeren Bestückungsleistungen, welche in der Regel Varianten-Linien sind, werden Baugruppen(-typen) vorwiegend mit temporär erstellten Rüstungen (Cluster-Rüstungen) gefertigt.

Es gibt unterschiedliche Maschinentaktzeiten bei der Fertigung der Baugruppen auf den unterschiedlichen Bestückungslinientypen - in dem oben genannten Kontext auf der Rennerlinie und einer oder mehreren der verbleibenden Bestückungslinien. Es gibt auch sogenannte externe Taktzeiten, die durch die Bearbeitung mittels eines Druckers oder durch die Verweildauer in einem Ofen verursacht werden. Diese externe Taktzeit liegt typischerweise bei ca. 16s. Maschinentaktzeiten unterhalb dieser externen Taktzeit führen zu unproduktiven Wartezeiten auf den externen Taktzeitgeber.

Die Aufgabe der Erfindung besteht darin, ein Verfahren sowie zugehörige Vorrichtung/System bzw. Anordnung anzugeben, bei dem eine optimale Zuordnung von Baugruppentypen auf die ausgewählte Bestückungslinie und die eine oder mehrere normale Bestückungslinien bestimmt wird, um einen möglichst hohen Gewinn hinsichtlich der Gesamtproduktionszeit bei der Bestückung/Fertigung der Baugruppentypen nach deren Zuordnung auf die oben genannten Bestückungslinientypen zu erzielen.

Diese Aufgabe wird durch die unabhängigen Ansprüche gelöst. Vorteilhafte Weiterbildungen sind Gegenstand der abhängigen Ansprüche.

Die Erfindung beansprucht Computerimplementiertes Verfahren zur Bestimmung einer optimalen Zuordnung von Baugruppentypen zu einer hinsichtlich seiner Bestückungsleistung ausgewählten Bestückungslinie mit einer ersten Taktzeit aus einer vorgegebenen Menge von Bestückungslinien zur Bestückung von Baugruppen dieser Baugruppentypen mit Bauelementen eines oder mehrerer Bauelementtypen und zu mindestens einer verbleibenden Bestückungslinie mit einer zweiten von der ersten unterschiedlichen Taktzeit aus der genannten Menge von Bestückungslinien, umfassend folgende Schritte:

a) Ermitteln einer erwarteten Produktionszeit für jeden Baugruppentyp der zu bestückenden Baugruppen und für jede Bestückungslinie unter Berücksichtigung von einer erfassten jeweiligen Taktzeit des Baugruppentyps auf den Bestückungslinien und unter Berücksichtigung einer pro Baugruppentyp vorgegebenen Stückzahl an zu bestückenden Baugruppen;

b) Zuordnen von einer Menge von Baugruppentypen der genannten Menge von Baugruppentypen zu einer vorgegebenen Anzahl an Festrüstungs-Rüstfamilien mit jeweils zugehörigen Festrüstungen, so dass eine Baugruppe eines Baugruppentyps einer Festrüstungs-Rüstfamilie mittels Bauelementen von Bauelementtypen der Festrüstung an der ausgewählten Bestückungslinie bestückt werden kann;

c) Optimieren der Zuordnung aus b) unter Berücksichtigung einer externen Taktzeit derart, dass für alle Baugruppentypen, die den Festrüstungs-Rüstfamilien zugeordnet werden, die Summe der Differenzen zwischen der erwarteten Produktionszeit pro Baugruppentyp, wenn er auf einer der mindestens einen verbleibenden Bestückungslinie mit der minimalen Produktionszeit unter der mindestens einen verbleibenden Bestückungslinie bestückt würde, und der erwarteten Produktionszeit auf der ausgewählten Bestückungslinie maximiert wird; und d) Ausgeben der optimierten Zuordnung in einer zur Steuerung und/oder zur Regelung der Bestückung der Baugruppen geeigneten Form.

Es kann demnach zumindest eine weitere Menge von Baugruppentypen der genannten Menge von Baugruppentypen auf die mindestens eine verbleibenden Bestückungslinie zugeordnet werden.

Erfindungsgemäß sollen Baugruppentypen Produktionszeitoptimal für eine ausgewählte Bestückungslinien zugeordnet werden und simultan Festrüstungs-Rüstfamilien für diese Bestückungslinie gebildet werden.

Eine Festrüstung wird - wie eingangs bereits erwähnt - durch Bereitstellen von Vorräten von Bauelementen der von ihr umfassten Bauelementtypen auf einem oder mehreren Rüsttischen gebildet.

Die Baugruppentypen für die ausgewählte(n) Bestückungslinie(n) sollen dabei möglichst so gewählt werden, dass diese Bestückungslinie(n) mit wenigen Festrüstungen betrieben werden kann/können, um auf diesen teuren Hochleistungs-Bestückungslinien (Rennerlinien) unproduktive Umrüstungen zu vermeiden.

Ein Bestückungsauftrag umfasst eine Stückzahl bzw. Menge von Baugruppen eines Baugruppentyps.

Die Erfindung bringt zudem den Vorteil mit sich, dass die Losgrößen gegenüber dem genannten Stand der Technik verringert werden können. Das bringt dann mehr Flexibilität in der Produktion der Baugruppen und der Produkte, in denen die gefertigten Baugruppen eingesetzt werden sollen.

Das obige Verfahren kann beliebig oft iteriert werden.

Die Bestimmung mindestens einer Festrüstungs-Rüstfamilie von Baugruppentypen kann mit den Schritten a) bis d) zentral auf einem Steuerungssystem vorzugsweise der nachstehend beschriebenen Art ausgeführt werden.

Gemäß einer Weiterbildung der Erfindung erfolgt die oben genannte Optimierung in Schritt c) vorzugsweise derart, dass für die Menge der Baugruppentypen, die keiner Festrüstungs-Rüstfamilie zugeordnet werden oder sind, die Anzahl der zur Bestückung auf einer der verbleibenden Bestückungslinien notwendigen Bauelementtypen minimiert wird.

Damit soll die Anzahl Bauelementtypen auf den verbleibenden Bestückungslinien, die vorzugsweise Variantenlinien sind, möglichst gering sein, um den Rüstaufwand auf diesen Bestückungslinien möglichst zu minimieren.

Da je mehr unterschiedliche Bauelementtypen auf einer Bestückungslinie gebraucht werden, desto mehr Varianten-Rüstungen werden gebraucht. Das verursacht dann einen erhöhten Auf-/Ab-/Umrüstaufwand.

Demnach ist es zweckmäßig, wenn zwischen obigen Schritt c) und der genannten Weiterbildung der Erfindung gewichtet werden wird bzw. werden kann.

Die Baugruppentypen, die einer Festrüstungs-Rüstfamilie zugeordnet werden oder sind, sollen die gleiche Baugruppenbreite aufweisen.

Eine Weiterbildung der Erfindung sieht vor, dass für die auf der ausgewählten Bestückungslinie zu bestückenden Baugruppentypen die Summe der erwarteten Produktionszeiten pro Baugruppentyp eine maximale zeitliche Auslastung der ausgewählten Bestückungslinie nicht überschreiten darf.

Eine Weiterbildung der Erfindung sieht vor, dass für die auf der ausgewählten Bestückungslinie zu bestückenden Baugruppentypen die Summe der erwarteten Produktionszeiten pro Baugruppentyp eine minimale zeitliche Auslastung der ausgewählten Bestückungslinie nicht unterschreiten darf.

Eine Weiterbildung der Erfindung sieht vor, dass als Optimierungsmethode für die Zuordnung der Baugruppentypen die gemischt ganzzahlige lineare Programmierung angewendet wird.

Die zur Steuerung bzw. zur Regelung der Bestückungsauftragserfüllung und der damit verbundenen, zur Steuerung der Bestückung der Baugruppen geeignete Form ist vorzugsweise computerlesbar. Mit der Steuerung bzw. Regelung der Bestückung der Baugruppen, die entsprechenden Baugruppentypen zugeordnet sind, wird die Bestückung der Baugruppen letztendlich ausgeführt.

Anhand der bestimmten optimalen Zuordnung von Baugruppentypen in genannter Form kann die Bestückung von Baugruppen gesteuert und/oder geregelt und/oder zur Ausführung gebracht werden. Dabei ergibt sich die Festrüstung aus einer entsprechenden Festrüstungs-Rüstfamilie der bestimmten Festrüstungs-Rüstfamilien, der die Baugruppentypen der zu bestückenden Baugruppen zugeordnet werden/sind.

Beim obigen computer-implementierten Verfahren kann unter "erfasst" bzw. "erfassbar" bzw. "vorgegeben" bzw. "vorgebbar" verstanden werden, dass ein oder mehrere Eingabewerte bereits, beispielsweise durch Standard(werte), festgelegt sind oder von einem Benutzer und/oder durch Ausgabewerte eines vorgeschalteten computerimplementierten Verfahrens vorgegeben bzw. festgelegt werden und/oder vorgebbar bzw. festlegbar sind. Damit werden diese Eingabewerte vom computer-implementierten Verfahren erfasst.

In einer besonders bevorzugten Ausführungsform erfolgt das Optimieren mittels Gemischt Ganzzahliger Programmierung. Die Gemischt Ganzzahlige Programmierung stellt einen globalen Optimierungsansatz dar, der leicht erweiterbar ist und für die kommerzielle Lösungsverfahren bzw. Lösungsvorrichtungen, auch Solver genannt, erhältlich sind. Mittels Gemischt Ganzzahliger Programmierung können in einer Vielzahl möglicher Lösungen globale Maxima gefunden werden, so dass eine besonders gute Lösung gefunden werden kann. Erhältliche Verfahren bzw. Vorrichtungen zur Gemischt Ganzzahligen Programmierung werden laufend verbessert, sodass zu erwarten ist, dass zukünftig noch bessere Optimierungsergebnisse erzielbar sein werden.

Es kann ein Maß vorbestimmt sein bzw. werden, das einen Anteil an einem Unterschied zwischen der Kennzahl und einer maximal erreichbaren Zuordnungsgüte ausdrückt. Dieser Unterschied wird auch "Gap" genannt. Es wird bevorzugt, ein Optimierungsverfahren zu verwenden, bei dem dieser "Gap" bestimmt werden kann. Das kann insbesondere mit der Gemischt Ganzzahlige Programmierung erreicht werden.

Aus der erfindungsgemäßen optimierten Zuordnung von Baugruppentypen zu einer ausgewählten Bestückungslinie und Festrüstungs-Rüstfamilien resultiert eine Produktivitätssteigerung in einem Fertigungswerk, indem

- Rüstaufwand deutlich reduziert wird
- (längerfristig) der Bedarf an Rüstequipment reduziert wird,
- die Produktivität durch kürzere Durchlaufzeiten, kürzere Umrüstzeiten und Produktionszeiten erhöht wird.
- Flexibilität, Durchsatz, Liefertreue werden erhöht
- Niedrigere Losgrößen möglich sind.

Ein weiterer Aspekt der Erfindung sieht ein Steuerungssystem umfassend mindestens eine Recheneinheit, das dazu konfiguriert ist, ein computerimplementiertes Verfahren zur Bestimmung einer optimalen Zuordnung von Baugruppentypen zu einer hinsichtlich seiner Bestückungsleistung ausgewählten Bestückungslinie mit einer ersten Taktzeit aus einer vorgegebenen Menge von Bestückungslinien zur Bestückung von Baugruppen dieser Baugruppentypen mit Bauelementen und zu mindestens einer verbleibenden Bestückungslinie mit einer zweiten von der ersten unterschiedlichen Taktzeit aus der genannten Menge von Bestückungslinien auszuführen, aufweisend:

a) eine Berechnungseinheit zum Ermitteln einer erwarteten Produktionszeit für jeden Baugruppentyp der zu bestückenden Baugruppen und für jede Bestückungslinie unter Berücksichtigung von einer erfassten jeweiligen Taktzeit des Baugruppentyps auf den Bestückungslinien und unter Berücksichtigung einer pro Baugruppentyp vorgegebenen Stückzahl an zu bestückenden Baugruppen;

b) Zuordnungseinheit zum Zuordnen von einer Menge von Baugruppentypen der genannten Menge von Baugruppentypen zu einer vorgegebenen Anzahl an Festrüstungs-Rüstfamilien mit jeweils zugehörigen Festrüstungen, so dass eine Baugruppe eines Baugruppentyps einer Festrüstungs-Rüstfamilie mittels Bauelementen von Bauelementtypen der Festrüstung an der ausgewählten Bestückungslinie bestückt werden kann;

c) eine Optimierungseinheit zum Optimieren der Zuordnung aus b) unter Berücksichtigung einer externen Taktzeit derart, dass für alle Baugruppentypen, die den Festrüstungs-Rüstfamilien zugeordnet werden, die Summe der Differenzen zwischen der erwarteten Produktionszeit pro Baugruppentyp, wenn er auf einer der mindestens einen verbleibenden Bestückungslinie mit der minimalen Produktionszeit unter der mindestens einen verbleibenden Bestückungslinie bestückt würde, und der erwarteten Produktionszeit auf der ausgewählten Bestückungslinie maximiert wird; und

d) eine Ausgabeeinheit zum Ausgeben der optimierten Zuordnung in einer zur Steuerung und/oder zur Regelung der Bestückung der Baugruppen geeigneten Form.

Ein weiterer Aspekt sieht eine Steuerungsvorrichtung, umfassend wenigstens

- eine Empfangseinheit zum Empfangen einer optimierten Zuordnung von einer Menge von Baugruppentypen einer vorgegebenen Menge von Baugruppentypen zu einer vorgegebenen Anzahl an Festrüstungs-Rüstfamilien mit jeweils zugehörigen Festrüstungen in einer zur Steuerung und/oder zur Regelung der Bestückung der Baugruppen geeigneten Form, und
- eine Recheneinheit zum Verteilen von Baugruppentypen auf eine hinsichtlich seiner Bestückungsleistung ausgewählten Bestückungslinie mit einer ersten Taktzeit aus der Menge von Bestückungslinien und zu mindestens einer verbleibenden Bestückungslinie mit einer zweiten von der ersten unterschiedlichen Taktzeit aus der genannten Menge von Bestückungslinien mit Hilfe der unter Berücksichtigung einer externen Taktzeit optimierten Zuordnung, mit welcher die Summe der Differenzen zwischen der erwarteten Produktionszeit pro Baugruppentyp, wenn er auf einer der mindestens einen verbleibenden Bestückungslinie mit der minimalen Produktionszeit unter der mindestens einen verbleibenden Bestückungslinie bestückt würde, und der erwarteten Produktionszeit auf der ausgewählten Bestückungslinie maximiert wird.

Beansprucht wird ferner eine Anordnung umfassend ein Steuerungssystem und eine oder mehrere Steuerungsvorrichtungen der oben genannten Art, in welcher (Anordnung) die Bestückung von Baugruppen mit Hilfe der vom Steuerungssystem bestimmten Zuordnung von Baugruppentypen auf die eine oder mehreren ausgewählten Bestückungslinien sowie zu mindestens einer Festrüstungs-Rüstfamilie und mit Hilfe der einen oder mehreren Steuerungsvorrichtungen an einer der mindestens einen ausgewählten Bestückungslinie und der einen oder mehreren verbleibenden Bestückungslinien auf den genannten Bestückungslinien zur Ausführung gebracht werden kann. Es kann eine Steuerungsvorrichtung zentral für mehrere Bestückungslinien geben. Diese eine oder mehrere Steuerungsvorrichtung sind dabei mit dem Steuerungssystem verbunden, das abgesetzt von der Steuerungsvorrichtung und gegebenenfalls außerhalb des Fertigungswerks in einem Rechenzentrum bzw. in einer Cloud (Rechnerwolke) angeordnet sein kann. Es ist auch möglich, dass je eine Steuerungsvorrichtung für mehrere Bestückungslinien bzw. eine Steuerungsvorrichtung pro Bestückungslinie vorgesehen ist. Bei einer dezentralen Lösung kommunizieren die mehreren Steuerungsvorrichtungen entsprechend untereinander über ein drahtgebundenes und/oder drahtloses Kommunikationsnetzwerk, an das dann das Steuerungssystemsystem angeschlossen ist.

Die Anordnung bzw. das System bzw. die Vorrichtung und ggf. dazugehörige Einheit(en) sind dazu eingerichtet, solche Verfahrensschritte auszuführen, und können hardware-, firmware- und/oder softwaremäßig implementiert sein.

Ein weiterer Aspekt der Erfindung ist ein Computerprogramm(-produkt) umfassend einen durch eine Recheneinheit bzw. Prozessor ausführbaren Programmkode oder mehrere durch mehrere Recheneinheiten ausführbare und zusammenwirkende Programmkodemodule, welches oder welche Befehle aufweisen, die, die Ausführung des Verfahrens nach, einer der oben genannten Ausführungsformen auf dem Steuerungssystem der oben genannten Art und/oder in der Anordnung in der oben genannten Art veranlassen.

Das Computerprogramm bzw. -produkt kann auf einem computerlesbaren Speichermedium bzw. Datenträger gespeichert sein. Es ist möglich, dass das Computerprogramm(-produkt) in ein Datenträgersignal eingebunden ist, das für ein Herunterladen desselben von einem Server auf ein Speichermedium vorgesehen ist. Das Computerprogramm bzw. -produkt kann in einer üblichen Programmiersprache (z.B. C++, Java) erstellt sein. Eine Verarbeitungseinrichtung bzw. Prozessor für die Ausführung dessen Programmkodes/Programmkodemodule kann einen marktüblichen Computer oder Server mit entsprechenden Eingabe-, Ausgabe- und Speichermitteln umfassen. Diese Verarbeitungseinrichtung bzw. Recheneinheit kann im Steuerungssystem bzw. - vorrichtung bzw. in deren Einheiten integriert sein oder in der Anordnung bzw. den Anordnungskomponenten implementiert sein.

Das computer-implementierte Verfahren betrifft auch sogenannte Cloud-Dienste (Cloud = Rechnerwolke). Eine Rechnerwolke um fasst in der Regel ein oder mehrere Server, die von einem Cloud-Diensterbringers betrieben werden und dazu eingerichtet sind, einen Cloud-Dienst an einen Dienstnehmer z.B. einem Werkverbund zu liefern. Demnach kann Datenverarbeitungssystem in einer Rechnerwolke realisiert sein.

Die Anordnung, das Steuerungssystem und die Steuerungsvorrichtungen sowie das Computerprogramm(-produkt) und Datenträger bzw. Datenträgersignal können analog zum oben genannten Verfahren und dessen Weiterbildungen weiter- bzw. ausgebildet sein.

Weitere Vorteile, Einzelheiten und Weiterbildungen der Erfindung ergeben sich aus der nachfolgenden Beschreibung von Ausführungsbeispielen in Verbindung mit den Zeichnungen.

Figur 1 zeigt beispielhaft ein Bestückungssystem, und
Figur 2 zeigt ein Ablaufdiagramm des erfindungsgemäßen Verfahrens.

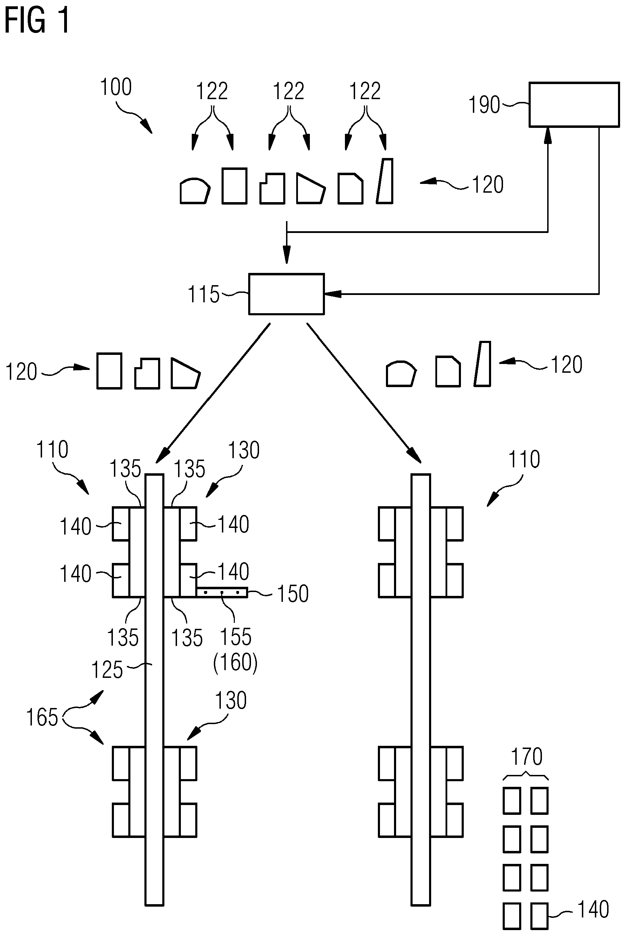

Figur 1 zeigt ein Bestückungssystem 100 mit einer oder mehreren Bestückungslinien. Das Bestückungssystem 100 umfasst eine oder mehrere Bestückungslinien 110 und eine Steuerungsvorrichtung 115. Dabei kann im Beispiel die links abgebildete Bestückungslinien eine hinsichtlich der Bestückungsleistung ausgewählte Bestückungslinie der eingangs erläuterten Art, auch Rennerlinie genannt, sein. Die rechts abgebildete Bestückungslinie entspricht im Beispiel einer verbleibenden "normalen" Bestückungslinie.

Jede Bestückungslinie 110 umfasst ein optionales Transportsystem 125 sowie einen oder mehrere Bestückungsautomaten 130. Jeder Bestückungsautomat 130 umfasst einen oder mehrere Bestückungsköpfe 135, die jeweils dazu eingerichtet sind, von einem Rüsttisch 140 Bauelemente bzw. -teile 155 aufzunehmen und an einer vorbestimmten Position auf der Baugruppe bzw. Leiterplatte 120 zu positionieren, die sich auf dem Transportsystem 125 befindet.

Während des Bestückungsvorgangs steht die Leiterplatte 120 bezüglich des Bestückungsautomaten 130 üblicherweise still. Die Rüsttische 140 umfassen jeweils eine Vielzahl Zuführungseinrichtungen 150, von denen in Figur 1 exemplarisch nur eine dargestellt ist. Jede Zuführungseinrichtung 150 hält einen Vorrat von Bauelementen 155 eines vorbestimmten Bauelementtyps 160 bereit. Für die Bauelemente 155 hat die Zuführungseinrichtung 150 ein Fassungsvermögen, das üblicherweise in Spuren ausgedrückt wird. Eine Spur ist üblicherweise 8 mm breit und die Zahl der Spuren jeder Zuführungseinrichtung 150 ist beschränkt, beispielsweise auf 40. Bauelemente 155 des gleichen Bauelementtyps 160 sind üblicherweise bereitgestellt in einem Gurt, auf einem Tablett oder in einer Röhre. Jeder Bauelementtyp 160 benötigt Platz in der Zuführungseinrichtung

150 mit einer vorbestimmten Anzahl an Spuren, die üblicherweise aneinander angrenzen müssen.

Jede Zuführungseinrichtung 150 kann zur Bereithaltung unterschiedlicher Bauelemente 155 konfiguriert werden und üblicherweise können unterschiedliche Zuführungseinrichtungen 150 an einem Rüsttisch 140 angebracht werden. Wird ein Bauelement 155 eines Bauelementtyps 160 am Bestückungsautomaten 130 benötigt, der nicht in einem der Rüsttische 140 vorhanden ist, so wird üblicherweise nicht einer der angebrachten Rüsttische 140 mit den benötigten Bauelementen 155 versehen, sondern komplett gegen einen anderen, entsprechend bestückten Rüsttisch 140 ausgetauscht. Das Aufrüsten eines einzuwechselnden Rüsttischs 140 mit Bauelementen 155 wird Vorrüstung genannt und kann eine Bearbeitungszeit im Stundenbereich erfordern.

Da ein Wechsel von Rüsttischen 140 an der Bestückungslinie 110 üblicherweise mit einem Produktionsstillstand verbunden ist, wird angestrebt, möglichst seltene Wechsel der Rüsttische 140 durchzuführen.

Ein Bestückungsauftrag umfasst die Stückzahl der zu bestückenden Leiterplatten eines Leiterplattentyps. Zur Bestückung einer anhand der Bestückungsaufträge vorbestimmbaren Menge von Leiterplatten 120 können Rüstungen gebildet sein, die jeweils Vorräte von Bauelementen 155 von vorbestimmten Bauelementtypen 160 umfassen, wobei jede Leiterplatte der Menge der Leiterplatten 120 mit Bauelementen 155 der Rüstung vollständig bestückt werden kann. Eine Rüstung kann realisiert sein durch eine Anzahl an Rüsttischen 140. In der Darstellung von Figur 1 sind eine Festrüstung 165, deren Rüsttische 140 an der Bestückungslinie 110 angebracht sind, und eine Variantenrüstung 170, deren Rüsttische 140 von der Bestückungslinie 110 getrennt sind, gebildet. Es können eine oder mehrere Festrüstungen 165 und eine oder mehrere Variantenrüstungen 170 vorgesehen sein. Ein angestrebter Fall ohne Variantenrüstungen 170 ist möglich.

Die Festrüstung 165 ist dazu eingerichtet, zumindest während eines Planungshorizonts, der beispielsweise ein halbes Jahr oder ein Jahr betragen kann, bezüglich seiner Bauelementtypen 160 unverändert bzw. bestehen zu bleiben. Es können also im Bedarfsfall zwar Bauelemente 155 an den Rüsttischen 140 der Festrüstung 165 nachgefüllt werden, die Zuordnung von Bauelementtypen 160 zu Spuren der Rüsttische 140 bleibt jedoch unverändert. Sind mehrere Festrüstungen 165 vorgesehen, so können diese innerhalb des Planungshorizonts gegeneinander ausgetauscht werden.

Eine Variantenrüstung 170 hingegen ist dazu eingerichtet, während des Planungshorizonts Bauelemente 155 unterschiedlicher Bauelementtypen 160 aufzunehmen, besteht aber nur temporär. Dazu werden üblicherweise die Rüsttische 170, während sie nicht an der Bestückungslinie 110 angebracht sind, von Bauelementen 155 vorbestimmter Bauelementtypen 160 abgerüstet und mit Bauelementen 155 anderer Bauelementtypen 160 aufgerüstet. Diese Umrüstung kann einen erheblichen Anteil manueller Arbeit umfassen und zeitaufwändig sein.

Eine Rüstfamilie, sei es eine Festrüstungs-Rüstfamilie bzw. Variantenrüstungs-Rüstfamilie, ist bestimmt als eine Menge von Leiterplattentypen, deren Leiterplatten auf einer Bestückungslinie bestückt werden können, ohne die Menge der Bauelementtypen zu ändern, die an der Bestückungslinie für die Bestückung bereitgehalten werden. D.h. es muss nicht umgerüstet werden.

Die Steuerungsvorrichtung 115 ordnet Leiterplattentypen 122, deren zugeordnete Leiterplatten 120 auf der Bestückungslinie 110 bestückt werden sollen, einer Rüstfamilie zu. Eine Rüstfamilie ist eine Menge von Leiterplattentypen 122, deren Leiterplatten 120 vollständig mit Bauelementen 155 bestückt werden können, die in der zugeordneten Rüstung 165, 170 bereitgestellt sind. Eine Rüstfamilie ist/wird üblicherweise genau einer Rüstung 165, 170 zugeordnet und umgekehrt.

Die Figur 1 zeigt neben dem Bestückungssystem 100 darüber hinaus eine Anordnung, die zudem ein Steuerungssystem 190 umfasst.

Eine oder mehrere Steuerungsvorrichtungen z.B. 115, die für eine oder mehrere Bestückungslinien 110 die Steuerung-/Regelung des Baugruppenbestückungsprozesses auf den Bestückungslinien zur Erfüllung der Bestückungsaufträge eingerichtet ist/sind, kann/können jeweils mit einem (zentralen) Steuerungssystem 190 in einer Cloud bzw. Rechnerwolke über drahtgebundene und/oder drahtlose Netzwerktechniken verbunden sein.

Das genannte Steuerungssystem ist dazu ausgestaltet, das nachfolgend noch näher erläuterte erfindungsgemäße computer-implementierte Verfahren zur Bestimmung zur Bestimmung einer optimalen Zuordnung von Baugruppentypen auszuführen. Das Steuerungssystem kann mit einem nicht dargestelltem Datenspeicher bzw. -medium gekoppelt sein und kann gegebenenfalls gespeicherte bzw. vorkonfigurierte Modelle der Bestückungssysteme abrufen. In das Steuerungssystem können eine oder mehrere nicht dargestellte Optimierungseinheiten integriert oder mit dieser gekoppelt sein, in denen sogenannte Solver, z.B. Cplex, Gurobi, eingesetzt werden können. Solver (Löser) sind spezielle mathematische Computerprogramme, die mathematische Probleme numerisch lösen können. In der Optimierungseinheit wird eine Zuordnung von Leiterplattentypen von erfassten Bestückungsaufträgen jeweils an die Bestückungslinien und an eine oder mehrere Festrüstungs-Rüstfamilie(n) optimiert. Mit den dadurch bestimmten Festrüstungs-Rüstfamilien werden die Festrüstungen, die an den Bestückungslinien zum Einsatz kommen sollen, festgelegt.

In der Optimierungseinheit kann auch eine Optimierung der oben genannten Variantenrüstungs-Rüstfamilien bzw. damit verbunden Variantenrüstung erzielt werden.

Eine nicht dargestellte Ausgabeeinheit des Steuerungssystems liefert die bestimmte optimale Zuordnung von Baugruppentypen in einer zur Steuerung und/oder zur Regelung der Bestückungsauftragserfüllung geeigneten Form. Eine solche Form sollte computerlesbar sein z.B. ein oder mehrere Excellisten in CSV-Format, die die einzelnen Baugruppentyp-Zuordnungen zu den Bestückungslinien und Festrüstungs-Rüstfamilien und gegebenenfalls zu den Varianten-Rüstfamilien enthält, wobei aus der Information aus dem Datenspeicher entnommen werden kann, welcher Bestückungslinientyp für welchen Braugruppentyp geeignet ist.

Anschließend kann bewertet werden, vorzugsweise mittels Simulation, welche Auswirkungen die optimierte Zuordnung auf den Betrieb der einzelnen Bestückungslinien haben. Es soll eine Zielfunktion der genannten Optimierung ihr Maximum bzw. eine vorgebbare Kennzahl erreichen.

Gegebenenfalls kann dann die Bestimmung der optimalen Zuordnung von Leiterplattentypen wiederholt werden.

Diese Excelliste(n) können dann jeweils an eine oder mehrere in einem Bestückungssystem angeordneten Steuerungsvorrichtungen 115 zu deren Empfang an einer nicht dargestellten Empfangseinheit gesendet werden. Eine nicht dargestellte Recheneinheit der Steuerungsvorrichtung kann dann die Steuerung und/oder Regelung einer Bestückung von Leiterplatten entsprechend der bestimmten optimalen Zuordnung vornehmen.

Zusätzlich und alternativ ist es möglich, dass die Steuerungsvorrichtung andere computerlesbare Steuerungssignale in Empfang annimmt, um daraus in ihrer Recheneinheit den Steuerungs-/Regelungsprozess zu veranlassen.

Das Bestücken der Baugruppen bzw. Leiterplatten wird üblicherweise so durchgeführt, dass die Bauelemente 155 einzeln mittels Lötpaste an den Leiterplatten 120 fixiert werden. Anschließend können die bestückten Leiterplatten 155 in einem Reflow-Ofen fertig gestellt werden, in dem die Lötpaste vorübergehend aufgeschmolzen wird, sodass die Bauelemente 155 elektrisch und mechanisch mit Leiterbahnen an der Oberfläche der Leiterplatte 120 verbunden werden.

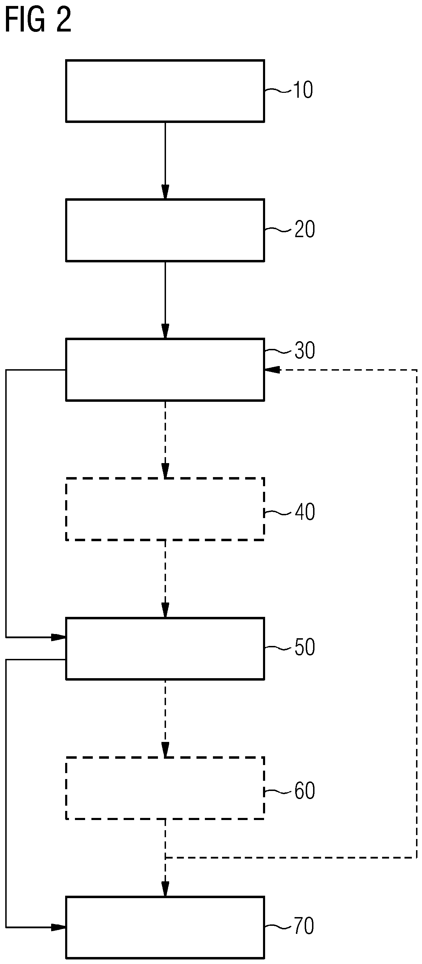

Figur 2 zeigt ein Ablaufdiagramm des erfindungsgemäßen Verfahrens umfassend folgende Schritte:
Im Schritt 10 wird die Menge der Bestückungslinien vorgegeben. Pro Bestückungslinie ist die Anzahl der Festrüstungs-Rüstfamilien vorgegeben. Zu jeder Festrüstung gehört eine Festrüstungs-Rüstfamilie. Aus der Menge der Bestückungslinien wird eine Menge von ausgewählten Bestückungslinien mit einer hohen Bestückungsleistung vorgegebenen.

Im nächsten Schritt 20 kann jeweils eine erwartete Produktionszeit für jeden Baugruppentyp der zu bestückenden Baugruppen erfasst werden. Dabei wird für jede Bestückungslinie eine erfasste bzw. erfassbare jeweilige Taktzeit des Baugruppentyps auf den Bestückungslinien berücksichtigt. Zudem wird eine pro Baugruppentyp vorgegebenen Stückzahl an zu bestückenden Baugruppen berücksichtigt.

In Schritt 30 wird eine Art an Startlösung für eine Zuordnung von einer Menge von Baugruppentypen der genannten Menge von Baugruppentypen zu einer vorgegebenen Anzahl an Festrüstungs-Rüstfamilien mit jeweils zugehörigen Festrüstungen bestimmt. Hierbei ist zu berücksichtigen, dass eine Baugruppe eines Baugruppentyps einer Festrüstungs-Rüstfamilie mittels Bauelementen von Bauelementtypen der Festrüstung an der ausgewählten Bestückungslinie bestückt werden kann.

Optional Schritt 40: Beim Zuordnen im Schritt 30 können verschiedene Nebenbedingungen zusätzlich berücksichtigt werden, die beispielsweise in der nachfolgenden Formulierung eines Gemischt ganzzahligen Programms näher beschrieben werden. Dieser Schritt 40 kann auch übersprungen werden, dann folgt nach Schritt 30 direkt Schritt 50.

Schritt 50: Auf der Basis der Kennzahl, die im Folgenden berechnet wird, kann die obige Zuordnung derart optimiert werden, dass ein Optimum, vorzugsweise ein Maximum, dieser Kennzahl erreicht wird. Neben anderen oben im Allgemeinen Teil der vorliegenden Anmeldung genannten Ausführungsformen der Kennzahl, wird die Kennzahl im Ausführungsbeispiel bevorzugt wie folgt berechnet: für alle Baugruppentypen, die den Festrüstungs-Rüstfamilien zugeordnet werden, wird als Kennzahl die Summe der Differenzen zwischen der erwarteten Produktionszeit pro Baugruppentyp, wenn er auf einer der mindestens einen verbleibenden Bestückungslinie mit der minimalen Produktionszeit unter der mindestens einen verbleibenden Bestückungslinie bestückt würde, und der erwarteten Produktionszeit auf der ausgewählten Bestückungslinie maximiert. Optional Schritt 60: Die Optimierung in Schritt 50 kann optional derart erfolgen, dass für die Menge der Braugruppentypen, die keiner Festrüstungs-Rüstfamilie zugeordnet werden oder sind, die Anzahl der zur Bestückung auf einer der verbleibenden Bestückungslinien notwendigen Bauelementtypen minimiert wird.

Optional wird das Verfahren mit Fortfahren mit Schritt 30 wiederholt, um die bestimmte optimale Zuordnung bezüglich der Kennzahl gegebenenfalls weiter zu optimieren.

Zuletzt wird in Schritt 70 das Ergebnis der bestimmten optimalen Zuordnung der Baugruppentypen in einer zur Steuerung und/oder zur Regelung der Bestückungsauftragserfüllung geeigneten (bevorzugt computerlesbaren) Form ausgegeben.

Zur Bestimmung einer optimalen Zuordnung von Baugruppentypen kann eine automatische Optimierung verwendet werden. Dabei können beliebige Optimierungsmethoden verwendet werden, beispielsweise auf der Basis von lokalen Suchverfahren oder metaheuristischen Algorithmen. Bei jedem Durchlauf der genannten Schritte wird die beste bislang bestimmte Zuordnung pseudo-zufällig oder nach einer Heuristik variiert, sodass sich veränderte Zuordnungen ergeben, von denen die mit der optimalen Zuordnungsgüte ausgewählt wird.

Ein Spezialfall von Optimierungsmethoden ist die lineare Optimierung. Sie befasst sich mit der Optimierung linearer Zielfunktionen über einer Menge, die durch lineare Gleichungen und Ungleichungen eingeschränkt ist. Sie ist Grundlage der Lösungsverfahren der (gemischt-) ganzzahligen linearen Optimierung. Im Zusammenhang mit MIP (mixed integer programming) bzw. MILP (gemischt ganzzahlige Lineare Programmierung) können für kleine IP-Programme (ganzzahlige Optimierungsmodelle) Standardsolver wie z.B. CPLEX, Scip, Gurobi, Xpress verwendet werden.

Schwieriger als die lineare Optimierung ist der Fall der nichtlinearen ganzzahliger Optimierung (MINLP), bei der die Zielfunktion, die Nebenbedingungen (NB) oder beide vorliegen können. Die Lösung wird erreicht, indem geeignete lineare Approximationen verwendet werden, so dass Standardsolver direkt verwendet werden können. Darüber hinaus können die oben genannten Standardsolver jeweils bestimmte Arten von nichtlinearen Problemen bereits lösen. Außerdem gibt es zusätzliche Solver, die auf die Lösung nichtlinearer Probleme spezialisiert sind (z.B. ANTIGONE, BARON).

Mit Hilfe von nichtlinearen ganzzahligen Optimierungsverfahren lassen sich Festrüstungs-Rüstfamilien ermitteln, mit denen eine auf alle Baugruppentypen bezogene optimale bzw. maximale Kennzahl erzielt wird.

Bevorzugterweise erfolgen die Schritte 30 - 60 durch Lösen eines Gemischt Ganzzahligen Programms. Optimierer auf der Basis Gemischt Ganzzahliger Programmierungen sind - wie oben erläutert - als kommerzielle Produkte erhältlich.

Vorteile der Gemischt ganzzahligen linearen Optimierung (MILP = Mixed Integer Linear Programming) sind:

- Globaler Optimierungsansatz.
- Leicht erweiterbar.
- Sehr gute kommerzielle Standard-Solver (z.B. Gurobi, SCIP, CPLEX, Ilog, Xpress), die in der Praxis weit verbreitet und bewährt sind.
- Für eine ermittelte Lösung ist bekannt, wie weit sie maximal von der optimalen Lösung entfernt ist (Gap).

Im Folgenden wir ein Beispiel für eine MILP-Formulierung zur Bestimmung der beschriebenen Zuordnung von Baugruppentypen gegeben.

Es werden die Festrüstungs-Rüstfamilien für die ausgewählte Bestückungslinien (Rennerlinie) so gebildet, dass der Produktionszeitgewinn gegenüber einer Fertigung der Baugruppen auf der Varianten-Line maximiert wird und gegebenenfalls zugleich die Anzahl der Bauelementtypen (auch als Bauelement-Varianz bezeichnet) auf der Varianten-Linie minimiert wird.

Dabei sind folgende Restriktionen einzuhalten:

- Einhaltung einer Mindest-Produktionszeit, da gewährleistet sein muss, dass die Renner-Linie nicht unterbelastet ist.
- Einhaltung einer maximalen Produktionszeit, da gewährleistet sein muss, dass die Renner-Linie nicht überlastet ist.
- In einer Festrüstungs-Rüstfamilie dürfen sich eventuell keine unterschiedlichen Leiterplattenbreiten befinden.
- Die Bauelement-Rüstung einer Festrüstungs-Rüstfamilie muss an der Bestückungslinie aufrüstbar sein.

In der MILP-Formulierung gelten die folgenden Bezeichnungen.

**Indices**

$C$     Menge der Bauelementtypen
$R$     Menge der Baugruppentypen
$R_c$     Menge der Baugruppentypen mit Bauelementtyp c

*Cl*      Menge der Feströstungen/Feströstungsfamilien für die Renner-Linie

**Parameter**

| | |
|---|---|
| $W_P$ | Zielfunktionsgewichtung hinsichtlich Produktionszeit |
| $W_S$ | Zielfunktionsgewichtung hinsichtlich Rüstaufwand auf der Varianten-Linie |
| $Width_c$ | Platzverbrauch eines Bauelementtyps c in Spuren |
| *LineCap* | Anzahl der Spuren der Bauelementtypen, die in der Rüstung einer Rüstfamilie der Renner-Linie Platz haben |
| *UpperTimeLimit* | Obere Produktionszeitschranke aller der Renner-Linie zugewiesenen Baugruppentypen |
| *LowerTimeLimit* | Untere Produktionszeitschranke aller der Renner-Linie zugewiesenen Baugruppentypen |
| $CycleTR_r$ | Taktzeit einer Baugruppe des Typs r auf der Renner-Linie |
| $CycleTV_r$ | Taktzeit einer Baugruppe des Typs r auf der Varianten-Linie |
| $Quantity_r$ | Stückzahl der zu fertigenden Baugruppen des Typs r |
| *ExtCycleTR* | Externe Taktzeit der Renner-Linie |
| *ExtCycleTV* | Externe Taktzeit der Varianten-Linie |
| $BoardWidth_r$ | Baugruppenbreite einer Baugruppe des Typs r |

**Binärvariablen**

$assign_{r,cl}$      Variable, die angibt, ob die Baugruppen des Typs r der Rüstfamilie *cl* zugeordnet werden. (In diesem Fall nimmt sie den Wert 1 an, anderenfalls den Wert 0)

$setupR_{c,cl}$      Variable, die angibt ob der Bauelementtyp c in der Rüstung der Feströstungs-Rüstfamilie *cl* gerüstet werden muss. (In diesem Fall nimmt sie den Wert 1 an, anderenfalls den Wert 0)

$setupV_c$      Variable, die angibt, ob der Bauelementtyp c auf der Varianten-Linie in Varianten-Rüstungen gerüstet werden muss. (In diesem Fall nimmt sie den Wert 1 an, anderenfalls den Wert 0)

**Zielfunktion**

$$Maximiere\ W_P \sum_{cl \in Cl} \sum_{r \in R} assign_{r,cl} \left( \max\{CycleTV_r, ExtCycleTV\} \right.$$
$$\left. - \max\{CycleTR_r, ExtCycleTR\} \right) Quantity_r$$

$$+ W_S \sum_{c \in C} -setupV_c$$

Nebenbedingungen:

(1) Jeder Baugruppentyp darf höchstens einer Rüstfamilie zugeordnet sein.

$$\sum_{cl \in Cl} assign_{r,cl} \leq 1 \qquad r \in R$$

(2) Die Bauelementtypen der Baugruppentypen einer Feströstungs-Rüstfamilie müssen in eine Feströstung für die

Renner-Linie passen.

$$\sum_{c \in C} \text{Width}_c \; setupR_{c,cl} \leq LineCap \qquad cl \in Cl$$

(3) Alle Bauelementtypen von Baugruppentypen einer Festrüstungs-Rüstfamilie müssen in der Rüstung der Festrüstungs-Rüstfamilie gerüstet werden.

$$\sum_{r \in R_c} \text{assign}_{r,cl} \leq |R_c| setupR_{c,cl} \qquad c \in C, cl \in Cl$$

(4) Falls nicht alle Baugruppentypen, die einen bestimmten Bauelementtyp c benötigen, auf die Festrüstungen der Renner-Linie zugewiesen werden, müssen die nicht zugewiesenen Baugruppen auch auf der Varianten-Linie gerüstet werden.

$$|R_c| - \sum_{r \in R_c} \text{assign}_{r,cl} \leq |R_c| setupV_c \qquad c \in C$$

(5) Die Summe der Produktionszeiten der Baugruppentypen einer Festrüstungs-Rüstfamilie darf die obere Produktionszeitschranke nicht überschreiten.

$$\sum_{cl \in Cl} \sum_{r \in R} assign_{r,cl} \; \max \{CycleTR_r, ExtCycleTR\} \; \text{Quantity}_r \leq UpperTimeLimit$$

(6) Die Summe der Produktionszeiten der Baugruppentypen einer Festrüstungs-Rüstfamilie darf die untere Produktionszeitschranke nicht unterschreiten.

$$\sum_{cl \in Cl} \sum_{r \in R} assign_{r,cl} \; \max \{CycleTR_r, ExtCycleTR\} \; \text{Quantity}_r \geq LowerTimeLimit$$

(7) Alle einer Festrüstungs-Rüstfamilie zugewiesenen Baugruppentypen müssen dieselbe Baugruppenbreite besitzen.

$$assign_{r,cl} + assign_{r',cl} \leq 1 \qquad cl \in Cl, r, r' \in R, BoardWidth_r \neq BoardWidth_{r'}$$

(8) Variablenrestriktionen

$$\text{assign}_{r,cl} \in \{0,1\} \qquad r \in R, cl \in Cl$$

$$\text{setupR}_{c,cl} \in \{0,1\} \qquad c \in C, cl \in Cl$$

$$\text{setupV}_c \in \{0,1\} \qquad c \in C$$

Das Verfahren lässt sich auch anwenden, für den Fall mit mehreren Varianten-Linien und Renner-Linien, jeweils eines Typs.

Mit der oben ausgeführten beispielhaften MILP-Formulierung und dem daraus resultierenden erzielten Produktionszeitgewinn konnten die Erfinder dazu beitragen, eine Einsparung von 2 von 15 Bestückungslinien in einem Fertigungswerk erreichen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Die Implementierung der vorstehend beschriebenen Prozesse oder Verfahrensabläufe/-schritte kann anhand von Befehlen bzw. Instruktionen erfolgen, die auf computerlesbaren, nichtflüchtigen Speichermedien oder in flüchtigen Computerspeichern (im Folgenden zusammenfassend als computerlesbare Speicher bezeichnet) vorliegen. Computerlesbare Speicher sind beispielsweise flüchtige Speicher wie Caches, Puffer oder RAM sowie nichtflüchtige Speicher wie Wechseldatenträger, Festplatten, usw.

Die vorstehend beschriebenen Funktionen oder Schritte können dabei in Form zumindest eines Instruktionssatzes in/auf einem computerlesbaren Speicher vorliegen. Die Funktionen oder Schritte sind dabei nicht an einen bestimmten Instruktionssatz oder an eine bestimmte Form von Instruktionssätzen oder an ein bestimmtes Speichermedium oder an einen bestimmten Prozessor oder an bestimmte Ausführungsschemata gebunden und können durch Software, Firmware, Microcode, Hardware, Prozessoren, integrierte Schaltungen usw. im Alleinbetrieb oder in beliebiger Kombination ausgeführt werden. Dabei können verschiedenste Verarbeitungsstrategien zum Einsatz kommen, beispielsweise serielle Verarbeitung durch einen einzelnen Prozessor oder Multiprocessing oder Multitasking oder Parallelverarbeitung usw.

Die Instruktionen können in lokalen Speichern abgelegt sein, es ist aber auch möglich, die Instruktionen auf einem entfernten System z.B. Cloud abzulegen und darauf via Netzwerk zuzugreifen.

Unter "rechner-/computergestützt" bzw. "computerimplementiert" kann im Zusammenhang mit der Erfindung beispielsweise eine Implementierung des Verfahrens verstanden werden, bei dem insbesondere ein Prozessor bzw. eine Recheneinheit, der Teil des Steuerungssystems bzw. der (Steuerungs- bzw. Verarbeitungs-)vorrichtung bzw. -einheit und/oder eines Computers und/oder eines oder mehrerer Dienste in einer Rechnerwolke (Cloud) eines Diensterbringers sein kann, mindestens einen Verfahrensschritt des Verfahrens ausführt.

Sofern es in der nachfolgenden Beschreibung nicht anders angegeben ist, beziehen sich die Begriffe "abbilden", "nachbilden", "empfangen", "anwenden", "ausgeben", "bereitstellen" und dergleichen vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt oder vorliegen können.

Der Begriff "Prozessor", "zentrale Signalverarbeitung", "Steuereinheit" oder "Datenauswertemittel", wie hier verwendet, umfasst Verarbeitungsmittel im weitesten Sinne, also beispielsweise Server, Universalprozessoren, Grafikprozessoren, digitale Signalprozessoren, anwendungsspezifische integrierte Schaltungen (ASICs), programmierbare Logikschaltungen wie FPGAs, diskrete analoge oder digitale Schaltungen und beliebige Kombinationen davon, einschließlich aller anderen dem Fachmann bekannten oder in Zukunft entwickelten Verarbeitungsmittel. Prozessoren können dabei aus einer oder mehreren Systemen bzw. Vorrichtungen bzw. Einrichtungen bzw. Einheiten bestehen. Besteht ein Prozessor aus mehreren Vorrichtungen, können diese zur parallelen oder sequentiellen Verarbeitung bzw. Ausführung von Instruktionen ausgelegt bzw. konfiguriert sein. Unter einer "Speichereinheit" kann im Zusammenhang mit der Erfindung beispielsweise ein computerlesbares Speichermedium in Form von Arbeitsspeicher (engl. Random-Access Memory, RAM) oder eine Festplatte verstanden werden.

**Patentansprüche**

**1.** Computerimplementiertes Verfahren zur Bestimmung einer optimalen Zuordnung von Baugruppentypen (122) zu einer hinsichtlich seiner Bestückungsleistung ausgewählten Bestückungslinie mit einer ersten Taktzeit aus einer vorgegebenen Menge von Bestückungslinien (110) zur Bestückung von Baugruppen (120) dieser Baugruppentypen (122) mit Bauelementen (155) eines oder mehreren Bauelementtypen (160) und zu mindestens einer verbleibenden Bestückungslinie mit einer zweiten von der ersten unterschiedlichen Taktzeit aus der genannten Menge von Bestückungslinien,
umfassend folgende Schritte:

a) Ermitteln einer erwarteten Produktionszeit für jeden Baugruppentyp der zu bestückenden Baugruppen und für jede Bestückungslinie unter Berücksichtigung von einer erfassten jeweiligen Taktzeit des Baugruppentyps auf den Bestückungslinien und unter Berücksichtigung einer pro Baugruppentyp vorgegebenen Stückzahl an zu bestückenden Baugruppen;
b) Zuordnen von einer Menge von Baugruppentypen der genannten Menge von Baugruppentypen zu einer vorgegebenen Anzahl an Festrüstungs-Rüstfamilien mit jeweils zugehörigen Festrüstungen (165), so dass eine Baugruppe eines Baugruppentyps einer Festrüstungs-Rüstfamilie mittels Bauelementen von Bauelementtypen der Festrüstung an der ausgewählten Bestückungslinie bestückt werden kann;

c) Optimieren der Zuordnung aus b) unter Berücksichtigung einer externen Taktzeit derart, dass für alle Baugruppentypen, die den Festrüstungs-Rüstfamilien zugeordnet werden, die Summe der Differenzen zwischen der erwarteten Produktionszeit pro Baugruppentyp, wenn er auf einer der mindestens einen verbleibenden Bestückungslinie mit der minimalen Produktionszeit unter der mindestens einen verbleibenden Bestückungslinie bestückt würde, und der erwarteten Produktionszeit auf der ausgewählten Bestückungslinie maximiert wird; und

d) Ausgeben der optimierten Zuordnung in einer zur Steuerung und/oder zur Regelung der Bestückung der Baugruppen geeigneten Form.

2. Verfahren nach dem vorhergehenden Anspruch, **dadurch gekennzeichnet, dass** die Optimierung in 1c) derart erfolgt, dass für die Menge der Baugruppentypen, die keiner Festrüstungs-Rüstfamilie zugeordnet werden oder sind, die Anzahl der zur Bestückung auf einer der verbleibenden Bestückungslinien notwendigen Bauelementtypen minimiert wird.

3. Verfahren nach einem der vorhergehenden Ansprüche, **dadurch gekennzeichnet, dass** die Baugruppentypen, die einer Festrüstungs-Rüstfamilie zugeordnet werden oder sind, die gleiche Baugruppenbreite aufweisen.

4. Verfahren nach einem der vorhergehenden Ansprüche, **dadurch gekennzeichnet, dass** für die auf der ausgewählten Bestückungslinie zu bestückenden Baugruppentypen die Summe der erwarteten Produktionszeiten pro Baugruppentyp eine maximale zeitliche Auslastung der ausgewählten Bestückungslinie nicht überschreiten darf.

5. Verfahren nach einem der vorhergehenden Ansprüche, **dadurch gekennzeichnet, dass** für die auf der ausgewählten Bestückungslinie zu bestückenden Baugruppentypen die Summe der erwarteten Produktionszeiten pro Baugruppentyp eine minimale zeitliche Auslastung der ausgewählten Bestückungslinie nicht unterschreiten darf.

6. Verfahren nach einem der vorhergehenden Ansprüche, **dadurch gekennzeichnet, dass** als Optimierungsmethode für die Zuordnung die gemischt ganzzahlige lineare Programmierung angewendet wird.

7. Steuerungssystem (190) umfassend mindestens eine Recheneinheit, das dazu konfiguriert ist, ein computerimplementiertes Verfahren zur Bestimmung einer optimalen Zuordnung von Baugruppentypen zu einer hinsichtlich seiner Bestückungsleistung ausgewählten Bestückungslinie mit einer ersten Taktzeit aus einer vorgegebenen Menge von Bestückungslinien (110) zur Bestückung von Baugruppen (120) dieser Baugruppentypen (122) mit Bauelementen (155) und zu mindestens einer verbleibenden Bestückungslinie mit einer zweiten von der ersten unterschiedlichen Taktzeit aus der genannten Menge von Bestückungslinien auszuführen, aufweisend:

a) eine Berechnungseinheit zum Ermitteln einer erwarteten Produktionszeit für jeden Baugruppentyp der zu bestückenden Baugruppen und für jede Bestückungslinie unter Berücksichtigung von einer erfassten jeweiligen Taktzeit des Baugruppentyps auf den Bestückungslinien und unter Berücksichtigung einer pro Baugruppentyp vorgegebenen Stückzahl an zu bestückenden Baugruppen;

b) Zuordnungseinheit zum Zuordnen von einer Menge von Baugruppentypen der genannten Menge von Baugruppentypen zu einer vorgegebenen Anzahl an Festrüstungs-Rüstfamilien mit jeweils zugehörigen Festrüstungen (165), so dass eine Baugruppe eines Baugruppentyps einer Festrüstungs-Rüstfamilie mittels Bauelementen von Bauelementtypen der Festrüstung an der ausgewählten Bestückungslinie bestückt werden kann;

c) eine Optimierungseinheit zum Optimieren der Zuordnung aus b) unter Berücksichtigung einer externen Taktzeit derart, dass für alle Baugruppentypen, die den Festrüstungs-Rüstfamilien zugeordnet werden, die Summe der Differenzen zwischen der erwarteten Produktionszeit pro Baugruppentyp, wenn er auf einer der mindestens einen verbleibenden Bestückungslinie mit der minimalen Produktionszeit unter der mindestens einen verbleibenden Bestückungslinie bestückt würde, und der erwarteten Produktionszeit auf der ausgewählten Bestückungslinie maximiert wird; und

d) eine Ausgabeeinheit zum Ausgeben der optimierten Zuordnung in einer zur Steuerung und/oder zur Regelung der Bestückung der Baugruppen geeigneten Form.

8. Steuerungsvorrichtung (115), umfassend wenigstens

- eine Empfangseinheit zum Empfangen einer optimierten Zuordnung von einer Menge von Baugruppentypen (122) einer vorgegebenen Menge von Baugruppentypen zu einer vorgegebenen Anzahl an Festrüstungs-Rüstfamilien mit jeweils zugehörigen Festrüstungen (165) in einer zur Steuerung und/oder zur Regelung der Bestückung der Baugruppen geeigneten Form, und
- eine Recheneinheit zum Verteilen von Baugruppentypen auf eine hinsichtlich seiner Bestückungsleistung ausgewählten Bestückungslinie mit einer ersten Taktzeit aus der Menge von Bestückungslinien (110) und zu mindestens einer verbleibenden Bestückungslinie mit einer zweiten von der ersten unterschiedlichen Taktzeit aus der genannten Menge von Bestückungslinien mit Hilfe der unter Berücksichtigung einer externen Taktzeit optimierten Zuordnung, mit welcher die Summe der Differenzen zwischen der erwarteten Produktionszeit pro Baugruppentyp, wenn er auf einer der mindestens einen verbleibenden Bestückungslinie mit der minimalen Produktionszeit unter der mindestens einen verbleibenden Bestückungslinie bestückt würde, und der erwarteten Produktionszeit auf der ausgewählten Bestückungslinie maximiert wird.

9. Anordnung umfassend ein Steuerungssystem nach Anspruch 7 und eine Steuerungsvorrichtung gemäß Anspruch 8.

10. Computerprogrammprodukt umfassend einen durch eine Recheneinheit ausführbaren Programmkode oder mehrere durch mehrere Recheneinheiten ausführbare und zusammenwirkende Programmkodemodule, welches oder welche Befehle aufweisen, die die Ausführung des Verfahrens nach einem der vorhergehenden Verfahrensansprüche auf dem Steuerungssystem nach Anspruch 7 oder in der Anordnung nach Anspruch 9 veranlassen.

11. Computerlesbarer Datenträger oder Datenträgersignal umfassend das Computerprogrammprodukt nach dem vorhergehenden Anspruch.

**Claims**

1. Computer-implemented method for determining an optimum assignment of module types (122) to an assembly line, having a first cycle time, selected with regard to its assembly capacity from a predefined set of assembly lines (110) for assembling modules (120) of these module types (122) with components (155) of one or more component types (160) and to at least one remaining assembly line, having a second cycle time which differs from the first, from said set of assembly lines,
comprising the following steps:

   a) ascertaining an expected production time for each module type of the modules to be assembled and for each assembly line, taking into consideration an acquired respective cycle time of the module type on the assembly lines and taking into consideration a parts number of modules to be assembled that is predefined per module type;
   b) assigning a set of module types of said set of module types to a predefined number of fixed-setup setup families containing respectively associated fixed setups (165), such that a module of a module type of a fixed-setup setup family is able to be assembled on the selected assembly line by way of components of component types of the fixed setup;
   c) optimizing the assignment from b), taking into consideration an external cycle time, such that, for all module types that are assigned to the fixed-setup setup families, the sum of the differences between the expected production time per module type, if it were to be assembled on one of the at least one remaining assembly lines with the minimum production time out of the at least one remaining assembly line, and the expected production time on the selected assembly line is maximized; and
   d) outputting the optimized assignment in a form suitable for controlling and/or for regulating the assembly of the modules.

2. Method according to the preceding claim, **characterized in that** the optimization in 1c) takes place such that, for the set of module types that are not assigned to a fixed-setup setup family, the number of component types required for assembly on one of the remaining assembly lines is minimized.

3. Method according to either of the preceding claims, **characterized in that** the module types that are assigned to a fixed-setup setup family have the same module width.

4. Method according to one of the preceding claims, **characterized in that**, for the module types to be assembled on the selected assembly line, the sum of the expected production times per module type is not allowed to exceed a maximum temporal degree of use of the selected assembly line.

5. Method according to one of the preceding claims, **characterized in that**, for the module types to be assembled on the selected assembly line, the sum of the expected production times per module type is not allowed to drop below a minimum temporal degree of use of the selected assembly line.

6. Method according to one of the preceding claims, **characterized in that** mixed-integer linear programming is applied as optimization method for the assignment.

7. Control system (190) comprising at least one computing unit that is configured to carry out a computer-implemented method for determining an optimum assignment of module types to an assembly line, having a first cycle time, selected with regard to its assembly capacity from a predefined set of assembly lines (110) for assembling modules (120) of these module types (122) with components (155) and to at least one remaining assembly line, having a second cycle time which differs from the first, from said set of assembly lines, comprising:

a) a calculation unit for ascertaining an expected production time for each module type of the modules to be assembled and for each assembly line, taking into consideration an acquired respective cycle time of the module type on the assembly lines and taking into consideration a parts number of modules to be assembled that is predefined per module type;
b) an assignment unit for assigning a set of module types of said set of module types to a predefined number of fixed-setup setup families containing respectively associated fixed setups (165), such that a module of a module type of a fixed-setup setup family is able to be assembled on the selected assembly line by way of components of component types of the fixed setup;
c) an optimization unit for optimizing the assignment from b), taking into consideration an external cycle time, such that, for all module types that are assigned to the fixed-setup setup families, the sum of the differences between the expected production time per module type, if it were to be assembled on one of the at least one remaining assembly lines with the minimum production time out of the at least one remaining assembly line, and the expected production time on the selected assembly line is maximized; and
d) an output unit for outputting the optimized assignment in a form suitable for controlling and/or regulating the assembly of the modules.

8. Control device (115), comprising at least

- a reception unit for receiving an optimized assignment of a set of module types (122) of a predefined set of module types to a predefined number of fixed-setup setup families each containing associated fixed setups (165) in a form suitable for controlling and/or for regulating the assembly of the modules, and
- a computing unit for distributing module types to an assembly line, having a first cycle time, selected with regard to its assembly capacity from the set of assembly lines (110) and to at least one remaining assembly line, having a second cycle time which differs from the first, from said set of assembly lines using the assignment optimized taking into consideration an external cycle time, by way of which the sum of the differences between the expected production time per module type, if it were to be assembled on one of the at least one remaining assembly lines with the minimum production time out of the at least one remaining assembly line, and the expected production time on the selected assembly line is maximized.

9. Arrangement comprising a control system according to Claim 7 and a control device according to Claim 8.

10. Computer program product comprising program code able to be executed by a computing unit or multiple interacting program code modules able to be executed by multiple computing units and which contain instructions that prompt the execution of the method according to one of the preceding method claims on the control system according to Claim 7 or in the arrangement according to Claim 9.

11. Computer-readable data carrier or data carrier signal comprising the computer program product according to the preceding claim.

**Revendications**

1. Procédé à mettre en œuvre par ordinateur pour déterminer une affectation optimale de types de modules d'assemblage (122) à une ligne de montage sélectionnée en fonction de sa capacité de montage avec un premier temps de cycle parmi un ensemble prédéfini de lignes de montage (110) pour monter des modules d'assemblage (120) de ces types de modules d'assemblage (122) avec des composants d'assemblage (155) d'un ou plusieurs types de composants d'assemblage (160) et à au moins une ligne de montage restante avec un deuxième temps de cycle différent du premier parmi ledit ensemble de lignes de montage,
qui comprend les étapes suivantes :

a) déterminer un temps de production attendu pour chaque type de module d'assemblage des modules d'assemblage à équiper et pour chaque ligne de montage en tenant compte d'un temps de cycle respectif saisi du type de module d'assemblage sur les lignes de montage et en tenant compte d'un nombre de modules à assembler prédéfini par type de module d'assemblage;
b) associer un ensemble de types d'assemblage de l'ensemble de types d'assemblage mentionné à un nombre prédéterminé de familles d'armatures fixes ayant chacune des armatures fixes (165) associées, de sorte qu'un assemblage d'un type d'ensemble d'une famille d'armatures fixes peut être monté au moyen de composants de types de composants de l'armature fixe sur la ligne de montage sélectionnée ;
c) optimiser l'affectation de b) en tenant compte d'un temps de cycle externe de telle sorte que, pour tous les types d'assemblages affectés aux familles d'armatures fixes, la somme des différences entre le temps de production attendu par type d'assemblage s'il était assemblé sur l'une de ladite au moins une ligne de montage restante avec le temps de production minimum sous ladite au moins une ligne de montage restante, et le temps de production attendu sur la ligne de montage sélectionnée, est maximisée ; et
d) émettre l'affectation optimisée sous une forme appropriée pour la commande et/ou la régulation du montage des modules d'assemblage.

2. Procédé selon la revendication précédente, **caractérisé en ce que** l'optimisation en 1c) est effectuée de telle sorte que, pour la quantité de types de modules d'assemblage qui ne sont pas ou ne seront pas affectés à une famille d'armatures fixes, le nombre de types de composants d'assemblage nécessaires pour le montage sur l'une des lignes de montage restantes est minimisé.

3. Procédé selon l'une des revendications précédentes, **caractérisé en ce que** les types d'assemblages qui sont ou seront associés à une famille d'armatures fixes présentent la même largeur du groupe d'assemblage.

4. Procédé selon l'une des revendications précédentes, **caractérisé en ce que**, sur la ligne de montage sélectionnée, pour les types de modules à assembler, la somme des temps de production attendus par type de module d'assemblage ne doit pas dépasser une charge temporelle maximale de la ligne de montage sélectionnée.

5. Procédé selon l'une des revendications précédentes, **caractérisé en ce que**, pour les types de modules d'assemblage à monter sur la ligne de montage sélectionnée, la somme des temps de production attendus par type de module d'assemblage ne doit pas être inférieure à une charge temporelle minimale de la ligne de montage sélectionnée.

6. Procédé selon l'une des revendications précédentes, **caractérisé en ce que** l'on utilise comme méthode d'optimisation pour l'affectation la programmation linéaire à nombres entiers mixtes.

7. Système de commande (190) comprenant au moins une unité de calcul qui est configurée pour exécuter un procédé à mettre en œuvre par ordinateur pour déterminer une affectation optimale de types de modules d'assemblage à une ligne de montage sélectionnée du point de vue de sa performance de montage avec un premier temps de cycle à partir d'une quantité prédéfinie de lignes de montage (110) pour monter des modules d'assemblage (120) de ces types de modules d'assemblage (122) avec des composants d'assemblages (155) et à au moins une ligne de montage restante avec un deuxième temps de cycle différent du premier à partir de ladite quantité de lignes de montage, présentant :

a) une unité de calcul pour déterminer un temps de production attendu pour chaque type de module d'assemblage des modules d'assemblage à monter et pour chaque ligne de montage en tenant compte d'un temps de cycle respectif saisi du type de module d'assemblage sur les lignes de montage et en tenant compte d'un nombre de pièces prédéfini par type de module d'assemblage des modules d'assemblage à monter;
b) une unité d'affectation pour affecter un ensemble de types de modules d'assemblage de l'ensemble mentionné de types de modules d'assemblage à un nombre prédéterminé de familles d'armatures fixes avec des armatures fixes respectives (165), de sorte qu'un module d'assemblage d'un type de module d'assemblage d'une famille d'armatures fixes peut être équipé au moyen de composants d'assemblage de types de composants d'assemblage de l'armature fixe sur la ligne de montage sélectionnée ;
c) une unité d'optimisation pour optimiser l'affectation de b) en tenant compte d'un temps de cycle externe de telle sorte que, pour tous les types d'assemblages affectés aux familles d'armatures fixes, la somme des différences entre le temps de production attendu par type d'assemblage s'il était assemblé sur l'une de ladite au moins une ligne de montage restante avec le temps de production minimum parmi ladite au moins une ligne de montage restante, et le temps de production attendu sur la ligne de montage sélectionnée, est maximisée ; et d) une unité de sortie pour délivrer l'association optimisée sous une forme appropriée pour la commande et/ou la régulation du montage des modules d'assemblage.

8. Dispositif de commande (115), comprenant au moins

- une unité de réception pour recevoir une affectation optimisée d'un ensemble de types de modules d'assemblage (122) d'un ensemble prédéterminé de types de modules d'assemblage à un nombre prédéterminé de familles d'armatures fixes avec des armatures fixes (165) respectivement associées, sous une forme appropriée pour la commande et/ou la régulation du montage des modules d'assemblage, et
- une unité de calcul pour répartir des types de modules d'assemblage sur une ligne de montage sélectionnée en fonction de sa capacité de montage avec un premier temps de cycle parmi l'ensemble de lignes de montage (110) et vers au moins une ligne de montage restante avec un deuxième temps de cycle différent du premier parmi ledit ensemble de lignes de montage à l'aide de l'attribution optimisée en tenant compte d'un temps de cycle externe, avec laquelle la somme des différences entre le temps de production attendu par type de module d'assemblage, s'il était assemblé sur l'une de la au moins une ligne de montage restante avec le temps de production minimal parmi la au moins une ligne de montage restante, et le temps de production attendu sur la ligne de montage sélectionnée est maximisée.

9. Dispositif comprenant un système de commande selon la revendication 7 et un dispositif de commande selon la revendication 8.

10. Produit de programme informatique comprenant un code de programme exécutable par une unité de calcul ou plusieurs modules de code de programme exécutables par plusieurs unités de calcul et coopérant entre eux, lequel ou lesquels présentent des instructions qui génèrent l'exécution du procédé selon l'une des revendications de procédé précédentes sur le système de commande selon la revendication 7 ou dans le dispositif selon la revendication 9.

11. Support de données lisible par ordinateur ou signal de support de données comprenant le produit de programme informatique selon la revendication précédente.

## FIG 1

## FIG 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2893791 B1
- EP 3219180 B1

- WO 2019011412 A1
- JP 5963873 B